# FASCICULE DE BREVET EUROPEEN

(11) **EP 1 138 111 B1**
(45) Date de publication et mention de la délivrance du brevet: **02.01.2003**
(21) Numéro de dépôt: 99971977.6
(22) Date de dépôt: 10.11.1999
(51) Int. Cl.: H02N 13/00, H01L 21/68

(54) **DISPOSITIF DE MAINTIEN ELECTROSTATIQUE**
ELECTROSTATISCHE HALTERORRICHTUNG
ELECTROSTATIC MAINTAINING DEVICE

(30) Priorité: 10.11.1998 FR 9814161
(43) Date de publication de la demande: 04.10.2001
(73) Titulaire: Semco Engineering S.A., 34196 Montpellier cedex 5 (FR)
(72) Inventeur: PELLEGRIN, Yvon, 625 rue de la Croix Verte, 34196 Montpellier cedex 5 (FR); HERNANDEZ, José, 625 rue de la Croix Verte, 34196 Montpellier cedex 5 (FR); CLAUDE, Richard, 625 rue de la Croix Verte, 34196 Montpellier cedex 5 (FR); HALE, William, Massachusetts, MA 02060 (US)
(74) Mandataire: Ravina, Bernard
(86) Numéro de dépôt international: FR9902767
(87) Numéro de publication internationale: WO00028654

(56) Documents cités:
- EP-A- 0 294 556
- EP-A- 0 473 930
- US-A- 4 724 510
- US-A- 5 001 594
- US-A- 5 400 209

## Description

La présente invention concerne un dispositif de maintien électrostatique particulièrement destiné au maintien de plaquettes de matériaux conducteurs ou semi-conducteurs tels que le silicium pendant qu'elles subissent des micro usinages ou tout autre type de traitement comme des traitements au plasma dans une enceinte sous vide par exemple.

Les différentes opérations de traitement tout au long du procédé de fabrication nécessitent de maintenir solidement la plaquette de matériau sur un support. Les plaquettes sont généralement déplacées d'un poste à l'autre par des moyens automatisés.

Il est connu de maintenir la plaquette par des brides prenant appui sur la périphérie de la surface supérieure de la plaquette, mais ces systèmes présentent l'inconvénient de monopoliser une partie de la plaquette qui ne pourra pas être traitée et sera donc perdue.

Il est également connu des systèmes de maintien électrostatique dont le principe est de placer la plaquette de matériau semi-conducteur sur une surface isolante et de disposer deux électrodes sous cette surface. Les deux électrodes sont soumises à une différence de potentiel. Le champ électrique créé par ces deux électrodes engendre alors un phénomène appelé « collage électrostatique ».

Les traitements ou micro usinages réalisés sur la plaquette nécessitent une très grande précision, la plaquette doit donc parfaitement être maintenue tout au long du cycle de traitement. Cependant, lorsque le matériau semi-conducteur constituent la plaquette ou le matériau constituant la semelle est soumis à un champ électrique de même polarité pendant un certain temps, celui-ci a tendance à accumuler des charges qui maintiendront la plaquette collée à la surface même lorsque le champ électrique extérieur ne sera plus appliqué.

Le brevet US 5452177 décrit un dispositif de maintien électrostatique sur une surface circulaire isolante sous laquelle sont placées au moins six électrodes disposées régulièrement par paires, en vis à vis par rapport au centre de la surface circulaire. Les électrodes sont alimentées par un générateur de tension alternative, fournissant six tensions différentes, chaque paire d'électrode étant alimentée cycliquement sous des polarités différentes. Les trois paires d'électrodes sont alimentées par des signaux décalés en phase de 120 degrés de manière à ce que deux paires d'électrodes soit alimentées au moment où la troisième change de polarité. Les fréquences de commutation sont de l'ordre de 30 Hz.

Pour parvenir à ce résultat, le système met en oeuvre des moyens d'alimentation des électrodes très complexes et donc coûteux, d'autre part, l'utilisation de tensions alternatives induit des courants dans la plaquette qui peuvent avoir des effets néfastes lorsque la plaquette est dotée de composants électroniques.

Le brevet EP 294 556 décrit un système de maintien électrostatique constitué de deux électrodes alimentées par une tension continue. Entre chaque cycle de maintien de l'objet, les polarités des électrodes sont inversées pour libérer les charges électrostatiques. La configuration des électrodes décrites dans ce brevet (sous forme de lignes alternées) n'est pas apte à optimiser la répartition des champs dans l'objet. Ainsi, la pression de collage électrostatique risque de ne pas être uniforme sur toute la surface de l'objet. D'autre part, ce brevet est limité à la présence de deux électrodes. Il n'est donc pas possible d'inverser la polarité en cours de traitement de la plaquette car celle-ci se décollerait au moment de l'inversion de polarité. Enfin, si la durée de maintien de l'objet est relativement importante, les charges électrostatiques accumulées rendront difficile son décollement.

Les principales difficultés rencontrées dans le collage électrostatique résident dans le fait de réussir à la fois à obtenir un collage puissant de l'objet et à le décoller très facilement donc à éviter toute accumulation de charges pendant son maintien.

La présente invention a pour objet de proposer un nouveau dispositif de maintien électrostatique de constitution simplifié donc économiquement intéressant tout en assurant un parfait maintien des plaquettes et en évitant toute accumulation de charges pouvant gêner le retrait de la plaquette.

A cet effet le dispositif est composé d'une surface électriquement isolante sous laquelle sont disposées au moins deux paires d'électrodes, caractérisé en ce que les paires d'électrodes sont alimentées cycliquement sous des polarités différentes de manière à ce qu'à tout moment au moins une paire d'électrode maintienne la plaquette.

Une autre caractéristique de l'invention réside dans la forme annulaire des électrodes. Ainsi, la pression de maintien de la plaquette est constante sur toute sa périphérie. De ce fait, la plaquette étant maintenue à tout moment sur sa périphérie, il n'y a aucun risque de déformation de celle-ci lorsqu'elle est soumise à une contrainte sur un point ponctuel de sa surface.

Selon une autre caractéristique de l'invention, la surface du dispositif de maintien présente des variations géométriques permettant de limiter la surface de contact entre la plaquette et le dispositif.

Les avantages et caractéristiques apparaîtront à la lecture de la description ci-après de formes de réalisation de l'invention données à titre d'exemple non limitatifs et illustrés par les dessins joints dans lesquels:
- la figure 1 représente en coupe et en vue de dessus le schéma du dispositif de maintien.
- la figure 2A représente une autre forme de réalisation du dispositif de maintien avec quatre électrodes et la figure 2B une variante avec huit électrodes.
- les figures 3A et 3B représentent d'autres configurations possibles des électrodes.

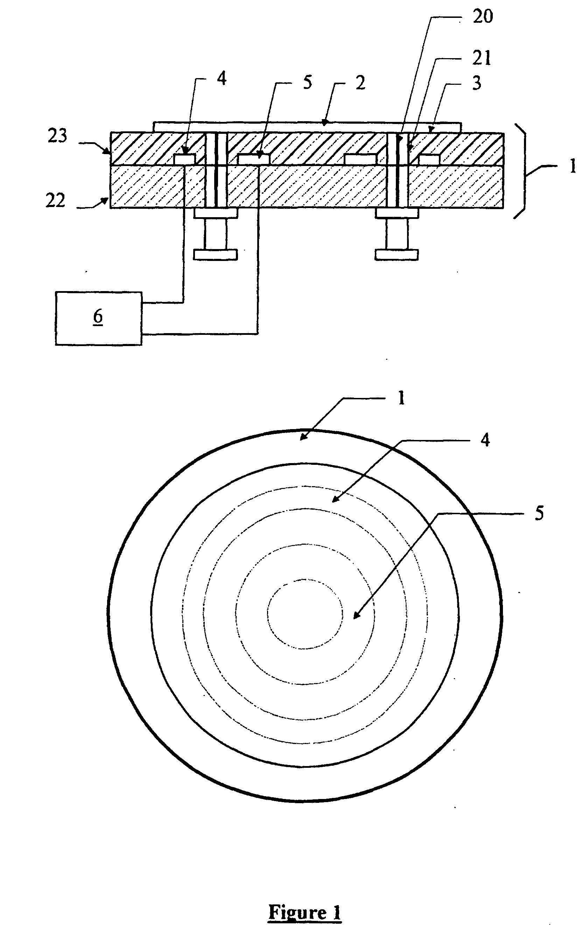

Comme on peut le voir sur la figure 1, le dispositif de maintien est composé d'une semelle (1) en matériau électriquement isolant sur laquelle repose la plaquette à maintenir (2) en contact avec la surface (3). Les électrodes (4) et (5) sont disposées sous cette surface (3). Selon un mode particulier de réalisation, la semelle (1) est constituée à partir d'une plaque de base (22) sur laquelle sont disposées les électrodes (4) et (5), puis l'ensemble est recouvert d'une couche de diélectrique (23). Les électrodes (4) et (5) et la couche de diélectrique (23) peuvent être réalisées par sérigraphie de couches épaisses selon des techniques connues de l'homme de métier. L'utilisation de la technique de sérigraphie de couches épaisses dans le cas de la couche de diélectrique (23) permet de créer facilement des variations géométriques sur la surface de contact avec la plaquette. Ces variations géométriques, constituées par des aspérités ou des plots par exemple, permettent de limiter la surface de contact entre la plaquette et le dispositif de collage. Ainsi, il est possible d'obtenir la surface optimum nécessaire au bon maintien de la plaquette. En effet, quand la surface de contact est trop faible, la force de maintien n'est pas suffisante et quand la surface de contact est trop importante, il devient difficile de décoller rapidement la plaque.

La plaque de base (22) peut être réalisée en tout type de matériau diélectrique c'est à dire électriquement isolant. Selon un mode particulier de réalisation de l'invention, la plaque de base (22) sera réalisée en alumine vierge. La plaque de base (22) peut également être réalisée en titane ou en molybdène. La couche de diélectrique (23) recouvrant les électrodes peut également être réalisée par tout type de matériau diélectrique à base de céramique par exemple.

La plaquette (2) est disposée à plat sur la surface (3). Selon un mode de réalisation de l'invention, les électrodes (4) et (5) sont de forme annulaire et disposées sous la surface (3) parallèlement à la plaquette. Dans cette configuration, les électrodes sont des anneaux concentriques de diamètres différents dont le centre correspond au centre de la semelle (1). La forme annulaire des électrodes est préférée puisque la plaquette (3) est de forme généralement circulaire, ce qui permet de la maintenir sur toute sa périphérie. Cependant, pour le maintien de pièces rectangulaires par exemple on pourrait imaginer les électrodes de forme correspondante. La plaquette (2) doit être disposée sur la surface (3) de manière à ce que son centre corresponde au centre des anneaux des électrodes. Afin d'obtenir une bonne répartition du champ électrique, les surfaces planes des anneaux formant les électrodes ont la même aire. L'électrode centrale (5) peut être réalisée sous la forme d'un anneau ou d'un disque. Les électrodes (4) et (5) sont soumises à une différence de potentiel par l'intermédiaire de l'alimentation (6) fournissant une tension continue de 1000 volts par exemple. Les lignes de champ créées entre la plaquette et les deux électrodes permettront le collage électrostatique de la plaquette (2) sur la surface (3). La pression de collage est proportionnelle au carré de la différence de potentiel entre les deux électrodes.

Lorsqu'ils sont soumis à un champ électrique intense, les matériaux constituants la semelle (1) et la plaquette (2) ont tendance à accumuler des charges électrostatiques qui risquent de gêner le décollement de la plaquette même lorsque les électrodes ne sont plus alimentées. Cette accumulation de charges électrostatiques est proportionnelle au temps d'alimentation du dispositif ainsi qu'à la valeur de la tension.

La plaquette reposant sur la surface (3) est généralement soulevée par des tiges (20) réparties sur sa surface pour ensuite être saisi par un bras manipulateur. Les tiges translatent verticalement dans des trous (21) traversant la semelle (1) sous l'action d'un vérin par exemple. On imagine ainsi très bien que les tiges endommageraient la plaquette si celle-ci restait collée à la surface (3).

Dans le cas d'un dispositif comportant deux électrodes et pour des procédés nécessitant un maintien de relativement courte durée, pour lesquelles la plaquette (2) n'a pas le temps de se charger, la solution consiste à inverser les polarités des deux électrodes entre chaque changement de plaquette. Ainsi, les charges accumulées par la semelle (1) pourront s'évacuer. A cet effet, l'alimentation est pourvue d'un système de changement de polarité automatique du type connu par exemple synchronisé avec le cycle d'usinage ou de traitement, à chaque fin de cycle par exemple les polarités sont inversées.

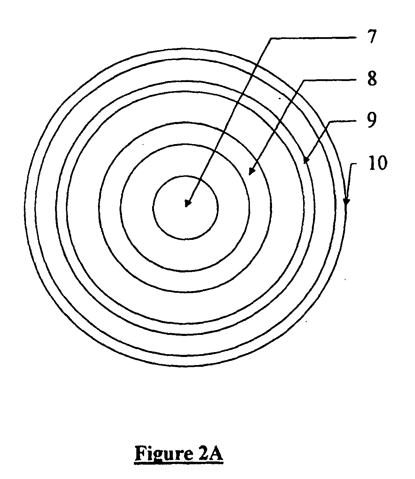

Pour des temps de traitement plus longs ou nécessitant une plus grande pression de collage, la présente invention propose d'utiliser plusieurs paires d'électrodes alimentées cycliquement sous des polarités différentes de manière à ce qu'à tout moment au moins une paire d'électrode maintienne la pièce. Selon un mode possible de réalisation de l'invention présenté sur la figure 2A, les électrodes sont réalisées sous la forme de quatre anneaux concentriques (7), (8), (9) et (10) fonctionnant par paire. L'alimentation est pourvue à cet effet d'un système de polarisation et d'alimentation cyclique des électrodes. Le cycle d'alimentation et de polarisation des électrodes peut par exemple être le suivant.

De to à t1, l'électrode (7) est alimentée en positif et l'électrode (9) en négatif.

De t1 à t2, l'électrode (7) est alimentée en positif et l'électrode (9) en négatif, l'électrode (8) en positif et l'électrode (10) en négatif.

A t2 les électrodes (7) et (9) n'ont plus besoin d'être alimentées puisque les électrodes (8) et (10) ont pris le relais.

De t2 à t3 l'électrode (8) est alimentée en positif et l'électrode (10) en négatif.

De t3 à t4 l'électrode (8) est alimentée en positif et l'électrode (10) en négatif, les électrodes (7) et (9) sont de nouveau alimentées mais sous des polarités différentes qui permettront l'évacuation des charges.

De t4 à t5 l'électrode (7) est alimentée en négatif et l'électrode (9) en positif.

Le cycle continue ainsi durant toute la phase de traitement ou d'usinage de la plaquette.

Les paires d'électrodes désignées ci-dessus ne sont qu'un exemple pour illustrer le fonctionnement du dispositif, on pourrait tout aussi bien imaginer les électrodes (7) et (10) fonctionnant ensembles ou toute autre combinaison possible.

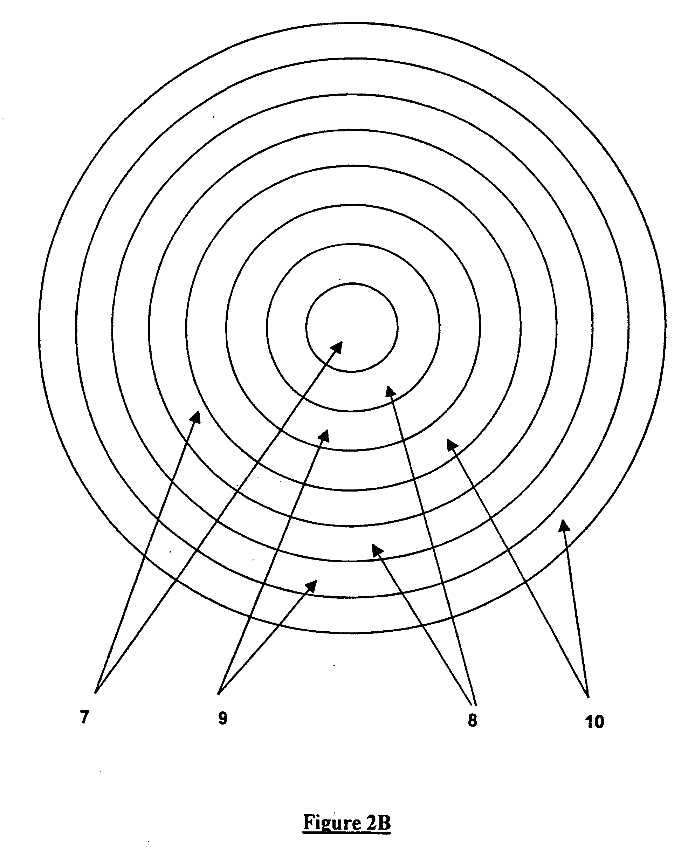

Selon un autre mode de réalisation représenté sur la figure 2B, chaque électrode est dédoublée, soit quatre paires d'électrode, de manière à obtenir une meilleure répartition de la pression de collage. Le cycle d'alimentation est le même que précédemment.

Selon ce principe d'inversion des polarités, la semelle peut rester maintenue indéfiniment sans accumulation de charges. De plus, comme une valeur importante de tension ne risque plus de charger la plaquette trop rapidement, les pressions de collage peuvent devenir beaucoup plus importantes.

Les temps de commutation des électrodes peuvent êtres variables suivant la tension de l'alimentation et suivant la capacité de la plaquette à se charger. A titre d'exemple pour une plaquette en silicium maintenue sous une tension de 1000 volts, le temps de commutation optimum est d'une minute, soit une fréquence de commutation de 0.016Hz. Il est bien évident que ce temps est variable et peut être réduit à quelques secondes ou moins ; cependant il est important d'éviter une commutation excessive qui endommagerait les composants de l'alimentation. D'une manière générale, la fréquence de commutation peut être comprise entre 0.01Hz et 1Hz. Les composants et le mode de réalisation de l'alimentation (6) n'ont pas besoin d'être décrits en détail puisqu'ils sont parfaitement connus de l'homme de métier. A titre d'exemple, les commutations peuvent être réalisées par des relais commandés par un automate programmable.

Le nombre d'anneaux formant les électrodes n'est absolument pas limité à quatre ou huit et leur nombre peut être bien supérieur sans que cela ne sorte du cadre de la présente invention.

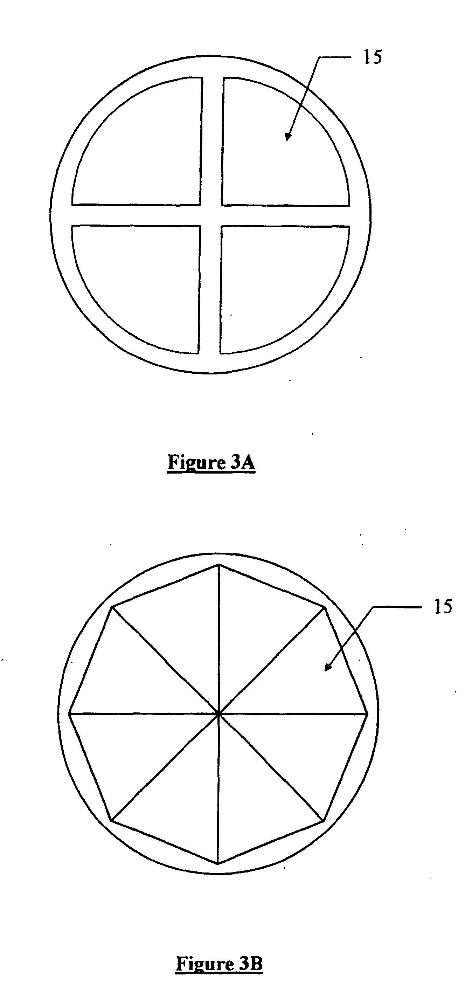

La configuration des électrodes peut être également réalisée sous de nombreuses autres formes présentées sur les figures 3A et 3B. La symétrie et les aires égales sont les points communs à toutes les configurations possibles des électrodes. Sur la figure 3A, les électrodes (15) sont des portions de disque au nombre de quatre fonctionnant par paires en vis à vis. Le nombre de portions formant les électrodes est variable suivant les contraintes dans la semelle et la répartition de pressions de collage souhaitée. Ainsi, pour des traitements nécessitant une faible pression de collage, les électrodes peuvent être au nombre de quatre comme représenté sur la figure 3A. Pour des pressions plus importantes, on peut multiplier le nombre de paires d'électrodes comme représenté sur la figure 3B.

## Revendications

1. Procédé de maintien électrostatique d'une plaquette de matériau conducteur ou semi-conducteur, sur un dispositif composé d'une semelle électriquement isolante (1) sur laquelle est disposée ladite plaquette (2), d'au moins deux paires d'électrodes (7), (8), (9) et (10) les deux électrodes de chaque paire étant soumises à une différence de potentiel générée par une alimentation (6) fournissant une tension continue et créant ainsi un champ électrique intense, lesdites électrodes disposées sous la surface isolante, **caractérisé en ce que** les paires d'électrodes sont alimentées cycliquement sous des polarités différentes de manière à ce qu'à tout moment au moins une paire d'électrode maintienne la plaquette.

2. Procédé de maintien électrostatique d'une plaquette de matériau conducteur ou semi-conducteur selon la revendication précédente **caractérisé en ce que** le cycle d'alimentation des électrodes est le suivant :
De to à t1, l'électrode (7) est alimentée en positif et l'électrode (9) en négatif.
De t1 à t2, l'électrode (7) est alimentée en positif et l'électrode (9) en négatif, l'électrode (8) en positif et l'électrode (10) en négatif.
A t2 les électrodes (7) et (9) n'ont plus besoin d'être alimentées puisque les électrodes (8) et (10) ont pris le relais.
De t2 à t3 l'électrode (8) est alimentée en positif et l'électrode (10) en négatif.
De t3 à t4 l'électrode (8) est alimentée en positif et l'électrode (10) en négatif, les électrodes (7) et (9) sont de nouveau alimentées mais sous des polarités différentes qui permettront l'évacuation des charges.
De t4 à t5 l'électrode (7) est alimentée en négatif et l'électrode (9) en positif.
Le cycle continue ainsi durant toute la phase de traitement ou d'usinage de la plaquette.

3. Procédé selon l'une des revendications précédentes **caractérisé en ce que** la fréquence de commutation des électrodes est comprise entre 0.01Hz et 1Hz.

4. Dispositif de mise en oeuvre du procédé selon la revendication 1 et les revendications 2 et 3 **caractérisé en ce que** les électrodes sont des anneaux concentriques.

5. Dispositif de mise en oeuvre du procédé selon la revendication 1 et les revendications 2 et 3 **caractérisé en ce que** la disposition des électrodes est symétrique ou concentrique par rapport au centre de la semelle (1).

6. Dispositif selon les revendications 4 et 5 **caractérisé en ce que** les surfaces planes des deux électrodes formant une paire ont la même aire.

7. Dispositif selon l'une des revendications 4, 5 et 6 **caractérisé en ce que** la surface de contact entre la plaquette et le dispositif de collage présente des variations géométriques (aspérités ou plots par exemple).

8. Dispositif selon l'une des revendications 4, 5, 6 et 7 **caractérisé en ce que** les électrodes et la couche de diélectrique (23) sont réalisées par sérigraphie de couches épaisses sur une plaque de base (22).

9. Dispositif selon l'un des revendications 4 à 8 **caractérisé en ce que** chaque électrode (7), (8), (9) et (10) est dédoublée.

## Claims

1. Process for electrostatically maintaining a small plate of conductive material or a semiconductor on a device comprising an electrically insulating base plate assembly (1) on which the said small plate (2) is placed, at least two pairs of electrodes (7), (8), (9) and (10) with both electrodes in each pair being subjected to a potential difference generated by a power supply (6) providing a direct current voltage and thus creating an intense electrical field, the said electrodes being arranged under the insulating surface, **characterised by** the fact that the pairs of electrodes are supplied cyclically with different polarities so that at any time at least one pair of electrodes holds the small plate.

2. Process for electrostatically maintaining a small plate of conductive material or a semiconductor according to the previous claim **characterised by** the fact that the power supply cycle for the electrodes is as follows:
From t0 to t1, electrode (7) is supplied positively and electrode (9) negatively.
From t1 to t2, electrode (7) is supplied positively and electrode (9) negatively, electrode (8) positively and electrode (10) negatively.
At t2 electrodes (7) and (9) no longer need to be supplied since electrodes (8) and (10) have taken over.
From t2 to t3, electrode (8) is supplied positively and electrode (10) negatively.
From t3 to t4, electrode (8) is supplied positively and electrode (10) negatively, electrodes (7) and (9) are again supplied but with different polarities that allow the charges to be evacuated.
From t4 to t5, electrode (7) is supplied negatively and electrode (9) positively.
The cycle continues thus throughout the small plate treatment or machining cycle.

3. Process according to one of the previous claims **characterised by** the fact that the switching frequency for the electrodes is between 0.01 Hz and 1 Hz.

4. Device for implementation of the process according to claim 1 and claims 2 and 3 **characterised by** the fact that the electrodes are in concentric rings.

5. Device for implementation of the process according to claim 1 and claims 2 and 3 **characterised by** the fact that the arrangement of the electrodes is symmetrical or concentric in relation to the centre of the base plate assembly (1).

6. Device according to claims 4 and 5 **characterised by** the fact that the plane surfaces of the two electrodes forming a pair have the same area.

7. Device according to one of the claims 4, 5 and 6 **characterised by** the fact that the contact surface between the small plate and the bonding device shows geometrical variations (asperities or studs, for example).

8. Device according to one of the claims 4, 5, 6 and 7 **characterised by** the fact that the electrodes and the layer of dielectric (23) are produced by silk-screen printing in thick layers on a base plate (22).

9. Device according to one of the claims 4 to 8 **characterised by** the fact that each electrode (7), (8), (9), and (10) is doubled.

## Patentansprüche

1. Verfahren für das elektrostatische Halten einer Plakette aus Leiter- oder Halbleiterwerkstoff auf einer Vorrichtung, die aus einer elektrisch isolierenden Sohle (1) besteht, auf der die besagte Plakette (2) angebracht ist, aus mindestens zwei Elektrodenpaaren (7), (8), (9) und (10), wobei die beiden Elektroden jedes Paars einem Potenzialunterschied ausgesetzt werden, der von einer Stromversorgung (5) erzeugt wird, die eine Gleichspannung liefert und so ein intensives elektrisches Feld erzeug, die besagten Elektroden befinden sich unter der isolierenden Fläche und dieses Verfahren wird **dadurch gekennzeichnet, dass** die Elektrodenpaare zyklisch unter unterschiedlichen Polaritäten mit Strom versorgt werden, so dass zu jedem Zeitpunkt mindestens ein Elektrodenpaar die Plakette festhält.

2. Verfahren für das elektrostatische Halten einer Plakette aus Leiter- oder Halbleiterwerkstoff gemäß dem obigen Anspruch und das durch den folgenden Zyklus der Stromversorgung der Elektroden gekennzeichnet ist:
Von to bis t1 werden die Elektrode (7) an Plus und die Elektrode (9) an Minus versorgt.
Von t1 bis t2 werden die Elektrode (7) an Plus und die Elektrode (9) an Minus , die Elektrode (8) an Plus und die Elektrode (10) an Minus versorgt.
Bei t2 brauchen die Elektroden (7) und (9) nicht mehr versorgt werden, weil sie von den Elektroden (8) und (10) abgelöst wurden.
Von t2 bis t3 werden die Elektrode (8) an Plus und die Elektrode (10) an Minus versorgt.
Von t3 bis t4 wird die Elektrode (8) an Plus versorgt und die Elektrode (10) an Minus, die Elektroden (7) und (9) werden erneut mit Strom versorgt, aber unter unterschiedlichen Polaritäten, die die Abführung der Lasten ermöglichen.
Von t4 bis t5 werden die Elektrode (7) an Minus und die Elektrode (9) an Plus versorgt.
Der Zyklus wird so während der gesamten Bearbeitungsphase der Plakette fortgesetzt.

3. Verfahren gemäß einer der oben genannten Ansprüche, das **dadurch gekennzeichnet ist, dass** die Elektrodenschaltfrequenz zwischen 0,01 Hz und 1 Hz liegt.

4. Vorrichtung für die Umsetzung des Verfahrens gemäß Anspruch 1 und den Ansprüchen 2 und 3, die **dadurch gekennzeichnet ist, dass** es sich bei den Elektroden um konzentrische Ringe handelt.

5. Vorrichtung für die Umsetzung des Verfahrens gemäß Anspruch 1 und den Ansprüchen 2 und 3, die **dadurch gekennzeichnet ist, dass** die Anordnung der Elektroden im Verhältnis zur Mitte der Sohle (1) symmetrisch oder konzentrisch ist.

6. Vorrichtung gemäß den Ansprüchen 4 und 5, die **dadurch gekennzeichnet ist, dass** die ebenen Flächen der beiden Elektroden eines Paares gleich groß sind.

7. Vorrichtung gemäß einem der Ansprüche 4, 5 und 6, die **dadurch gekennzeichnet ist, dass** die Kontaktfläche zwischen der Plakette und der Klebevorrichtung geometrische Schwankungen aufweist (z.B. Unebenheiten oder Stifte).

8. Vorrichtung gemäß einem der Ansprüche 4, 5, 6 und 7, die **dadurch gekennzeichnet ist, dass** die Elektroden und die Nichtleiterschicht (23) durch den Siebdruck dicker Schichten auf einer Grundplatte (22) hergestellt werden.

9. Vorrichtung gemäß einem der Ansprüche 4 bis 8, die **dadurch gekennzeichnet ist, dass** jede Elektrode (7), (8), (9) und (10) zweigeteilt ist.
